# EUROPEAN PATENT SPECIFICATION

(11) **EP 1 222 519 B1**
(45) Date of publication and mention of the grant of the patent: **21.12.2005**
(21) Application number: 00953214.4
(22) Date of filing: 18.08.2000
(51) Int. Cl.: G06F 3/02, H04Q 9/14

(54) **REMOTE CONTROL**
FERNBEDIENUNG
COMMANDE A DISTANCE

(30) Priority: 18.08.1999 FI 991752
(43) Date of publication of application: 17.07.2002
(73) Proprietor: Aplicom OY, 01620 Vantaa (FI)
(72) Inventor: RAUTIAINEN, Ari, FIN-44200 Suolahti (FI)
(74) Representative: Tanhua, Pekka Vilhelm
(86) International application number: PCT/FI2000/000701
(87) International publication number: WO 2001/013208

(56) References cited:
- EP-A1- 0 917 293
- DE-A1- 3 109 166
- US-A- 4 194 425
- US-A- 4 502 038
- US-A- 5 371 498

## Description

The invention relates to a method as defined in the preamble of claim 1 for controlling the operation of a remote control.

The invention also relates to a remote control as defined in the preamble of claim 5.

There is a previously known way of controlling the operation of a remote control, in which the keys are read by using a control based on an RC5 code. Such controls involve the problem that, when several keys are pressed simultaneously, the control circuit stops transmitting the key code altogether, or the control circuit makes too long pauses between the key code transmissions, so that the functions take place with too long a delay, and information that keys strokes have stopped is not rapidly received.

DE3109166 describes a remote control with an input keypad which allows for detecting two simultaneously pressed keys.

US5371498, EP0917293, US4502038 and US4194425 describe circuits for detecting simultaneously pressed keys.

The object of the invention is to overcome the shortcomings mentioned above and to provide a method for controlling the operation of a remote control and a remote control allowing several keys to be simultaneously pressed, in which the functions take place without long delays, and in which information that key strokes have stopped is rapidly obtained.

The method of the invention is characterised by the features defined in claim 1.

The remote control of the invention is characterised by the features defined in claim 5.

Preferred embodiments of the invention are described in the dependent claims.

The method of the invention for controlling the operation of a remote control is applied to a remote control comprising a feed device, such as a keyboard and/or a mouse or a similar pointer, comprising keys or push-buttons which are equipped with a switch and disposed in a related key conductor, and a transmitter for transmitting feed device data further to a computer or a similar host device. The method is characterised by
- generating start and end signals and intermediate successive activating signals for the key conductor corresponding to each key for intermittent successive indication of these;
- observing each key conductor and detecting each (one or more) pressed key on the basis of an activating signal; and
- generating a transmitter control signal on the basis of the start and end signals and the activating signals of each pressed key.

The invention offers the advantages of allowing several keys to be pressed simultaneously, of keys to be read without long delays and of getting rapid information when the keys are no longer being pressed.

The invention is explained below with reference to the accompanying drawings, in which
- figure 1: shows a block diagram of a remote control in accordance with the invention,
- figure 2: shows a circuit diagram of the key-indicating unit of the remote control of the invention,
- figure 3: shows a circuit diagram of keyboard switches,
- figure 4: shows a circuit diagram of the data encoding unit of the remote control of the invention,
- figure 5: shows a circuit diagram of the IR transmitter of the remote control of the invention,
- figure 6: shows the message frame of the remote control of the invention.

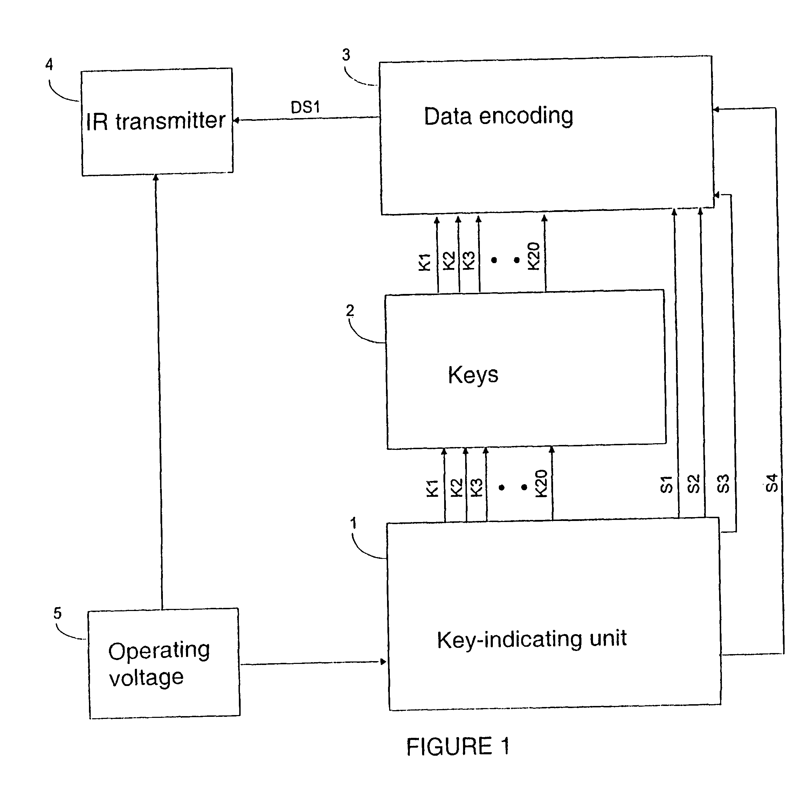

Figure 1 is a schematic view of the invention. The remote control includes a feed device, such as a keyboard and/or a mouse or a similar device, such as a keyboard matrix, comprising keys 2 or push-buttons equipped with switches SW1, SW2,...,SW20. Each key 2 in the keyboard is connected to a related key conductor K1, K2, K3,...,K20. The pressed keys of the keyboard 2 are identified by means of key-indicating unit 1. A control signal from the IR transmitter 4 is generated with data encoding unit 3.

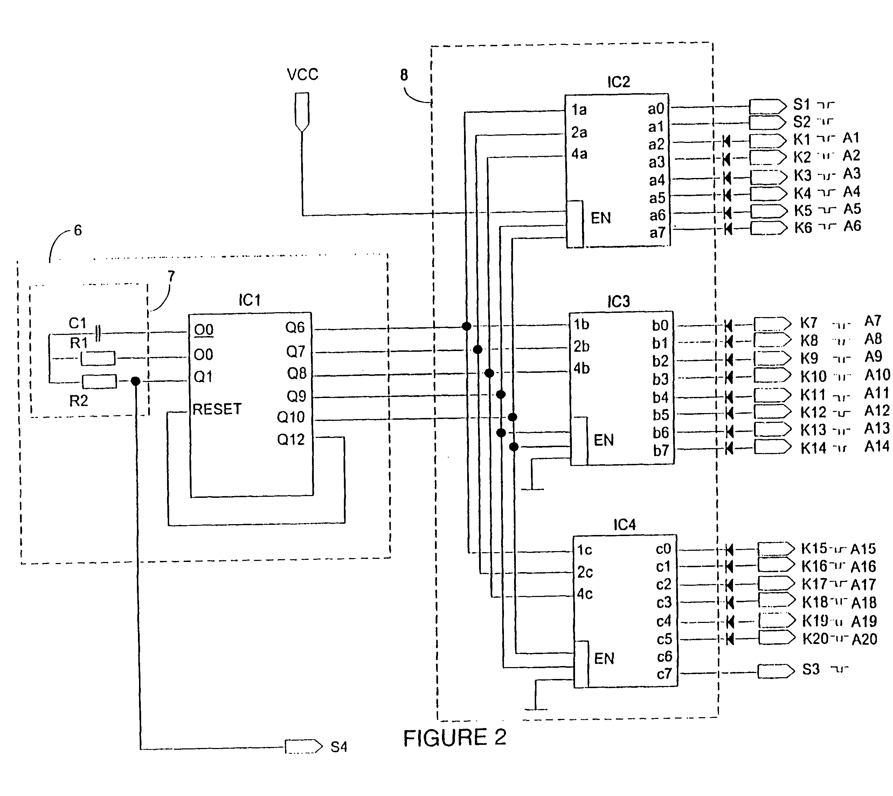

The key-indicating unit 1 of figure 2 comprises means for generating activating signals for key conductors K1, K2, K3,...,K20. Activating signals A1, A2, A3,..,A20 are generated periodically in sequence and are fed to each key conductor K1, K2, K3,...,K20. The activating signal is used to indicate the active key conductor. One single conductor can be active at a time. The key-indicating unit also comprises means for transmitting start and end signals S1, S2 and S3 to the data encoding unit 3. Key-indicating unit 1 is also used for generating the carrier wave frequency S4 of IR transmitter 4.

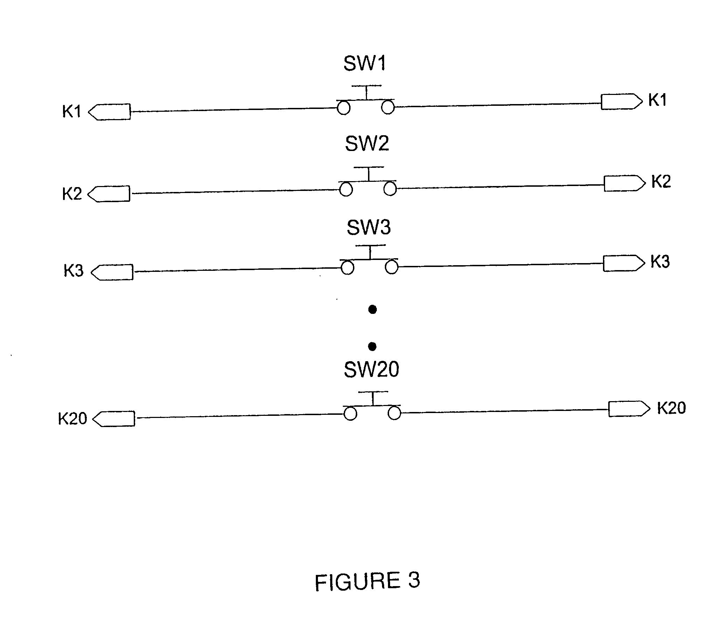

The switches pertaining to the keyboard 2 of figure 3 comprise a push-button switch SW1, SW2, ...,SW20 corresponding to each key of the keyboard.

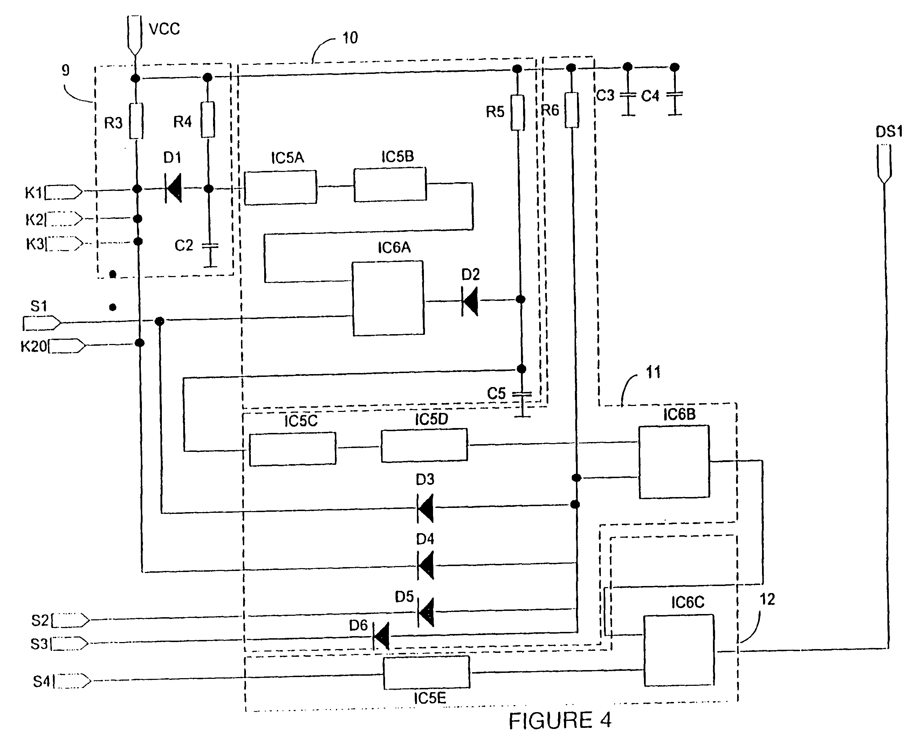

The data encoding unit 3 in figure 4 comprises means for detecting the activating signals of the pressed keys and an IR transmitter 4 for generating control signals DS1 from the activating signals A1, A2, A3,...,A20 of the pressed keyboard keys that have been detected and from start and end signals S1, S2 and S3.

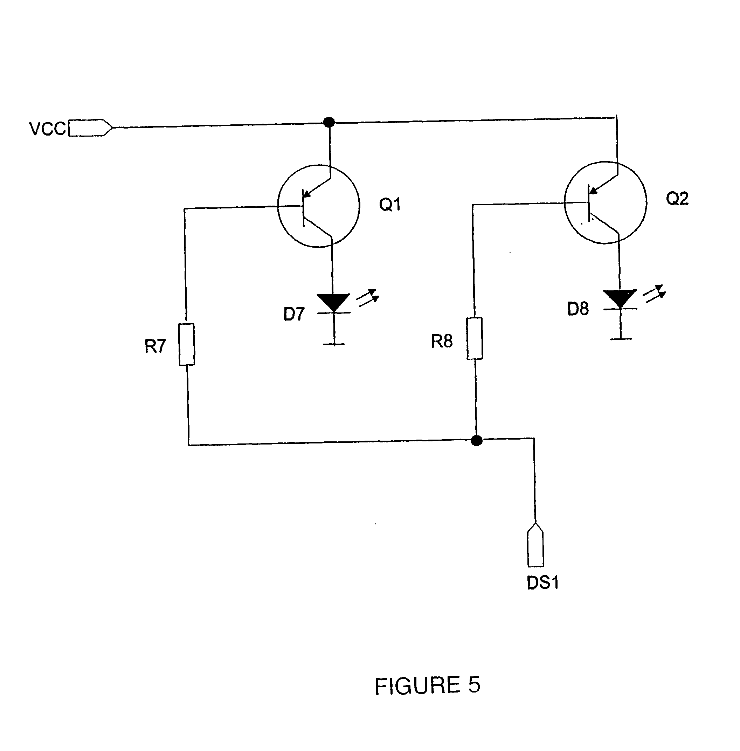

The IR transmitter 4 of figure 5 comprises means for receiving a control signal DS1 generated by data encoding unit 3 and for transmitting an IR signal to the IR receiver. The IR receiver is disposed in a device unit separate from the remote control, such as a computer, to which the key information is to be sent for interpretation or any processing.

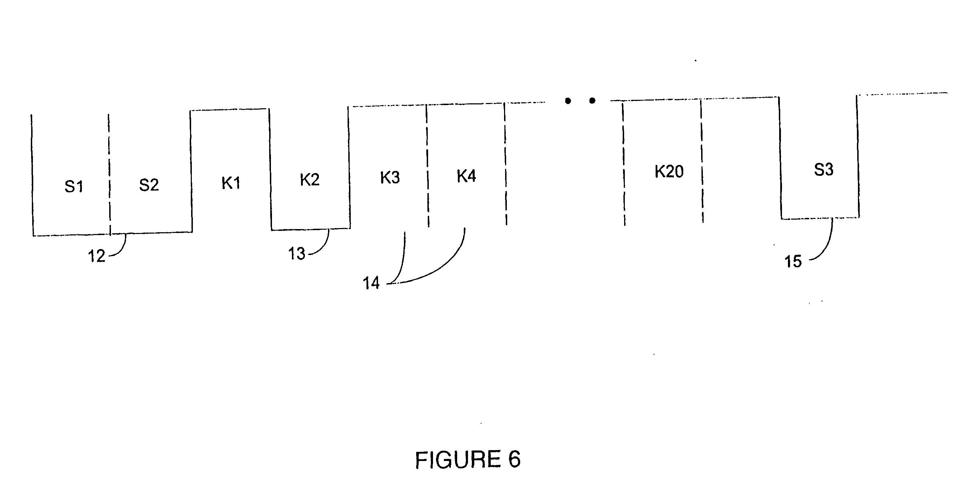

The message frame in figure 6 consists of start and end pulses 12, 15 and a pulse 13 corresponding to each pressed key. Each pressed key generates a pulse in its specific period 14, the number of pulses in the message frame being equal to the number of keys in the keyboard.

Key indicator unit 1 comprises means 6 for successive addressing, preferably by generating the binary addresses of key conductors K1,...,K20, and means 8 for successively decoding the addresses of key conductors K1, ...,K20. The addressing means are connected by key-indicating conductors to the means for decoding the addresses. On the basis of the addresses, successive activating signals A1,...,A20, as well as start and end signals S1, S2 and S3, are generated in address decoding means 8, and these signals are fed over diodes to the relative key conductors K1,..,K20 and connecting wires.

In the embodiment shown in the drawing, the means 6 for successive generation of the binary addresses of key conductors K1,...,K20 comprise a divider circuit IC1, which is e.g. of the type 74HC4060. The divider circuit IC 1 comprises an oscillator and a binary counter. The oscillator frequency is set by means of external passive components 7 disposed at the poles O0, O0 and Q1, such as capacitor C1 and resistors R1 and R2. The oscillator frequency serves to determine the repetition frequency of activating signals A1,...,A20 and the carrier wave frequency S4 of the IR transmitter. By means of the binary counter, the pulses of the pulse sequence generated by the oscillator are counted, and on the basis of this, the periodically varying parallel binary address (Q12 most significant bit) corresponding to a predetermined number of bits is obtained from outputs Q6, Q7, Q8, Q9, Q10 (and Q12). Output Q12 is connected to the RESET input. When a signal, i.e. binary 1, is obtained in output Q12, it is fed to the RESET input, and then the binary counter is reset and the counting restarts ascending from the beginning. The outputs Q6, Q7, Q8, Q9, Q10 are connected with means 8 for successive decoding of the addresses of the key conductors.

In the embodiment shown in the drawing, the means 8 for successive decoding of the addresses of the key conductors comprise an address decoder, which in this embodiment comprises three binary decoder circuits IC2, IC3, IC4, which are e.g. of the type 74HC138. The binary addresses of key conductors K1,...,K20, which are obtained from the outputs Q6, Q7, Q8, Q9, Q10 of divider circuit IC1, are fed to the inputs 1a, 2a, 4a; 1b, 2b, 4b; 1c, 2c, 4c of binary decoder circuits IC2, IC3, IC4. The outputs Q6, Q7, Q8 are connected to parallel address inputs 1a, 1b, 1c; 2a, 2b, 2c; 4a, 4b, 4c, whereas outputs Q9, Q10 are connected to the optional input EN of each circuit, one decoder circuit IC2, IC3, IC4 being alternatingly activated with combinations of the binary 1 and 0 fed to these. An activating signal A1,..., A20 varying from one connecting wire to another or start and end signals S 1, S2 and S3 are obtained from key conductors K1,...,K20 on the basis of address signals fed to the inputs in the outputs a0, a1,....,a7;b0, b1,...,b7;c1,c2,...,c7 of the decoding circuits IC2, IC3, IC4.

In this embodiment, activating signals A1,...,A20 and start and end signals S1, S2 and S3 are short pulses varying from zero level to the negative voltage level. The negative voltage level is called the earthing level below.

Data encoding unit 3 comprises means 9 and 10 for generating a first and a second time constant, means 11 for generating a message and means 12 for controlling the carrier wave of the IR transmitter 4.

In the embodiment of the drawing, the means 9 for forming a first time constant comprise resistors R3 and R4, diode D1 and capacitor C2. When a key is being pressed, a push-button switch SW1, SW2,...,SW20 corresponding to the key is switched on, and the key activating signal A1,...,A20 decreases the voltage level of one end of the resistor R3 from the release condition to the earthing level voltage. Then capacitor C2 is discharged over diode D1 during each successive reading cycle. Together with resistor R4, capacitor C2 forms a first time constant, which has the function of actuating the remote control long enough for at least one message frame containing only start and end signals to be transmitted after the key strokes have ended.

The means 10 for forming a second time constant comprise inverters IC5A and IC5B, an OR-gate IC6A, a diode D2, a resistor R5 and a capacitor C5. The signal obtained from the means 9 for forming the first time constant controls schmitt-trigger inverters IC5A and IC5B, which are e.g. of the type 74HC14, by means of which the first time constant is converted into a logic level 1 with sharp edges. This signal is conducted to the OR-gate IC6A, which is e.g. of the type 74HC32, which awaits the start signal S1 from the output a0 of the binary decoding circuit IC2 of the keyboard-indicating unit 1. Having received the start signal S1, the OR-gate IC6A discharges the capacitor C5 over the diode D5. Together with resistor R5, the capacitor C5 forms a second time constant, whose function is to start the key data transmission.

The means 11 for generating a message comprise inverters IC5C and IC5D, an OR-gate IC6B, diodes D3, D4, D5 and D6 and a resistor R6. The signal obtained from the means 10 for forming a second time constant controls schmitt-trigger inverters IC5C and IC5D, which are e.g. of the type 74HC14, by means of which the second time constant is converted into a logic level 1 with sharp edges. This signal is taken to the OR-gate IC6B, which is e.g. of the type 74HC32. The control signal of the IR transmitter can proceed over the second input of the OR-gate IC6B. The data line has a pull-up resistor R6, which raises the voltage level from the earthing level over diodes D3 and D5, over start pulse 12, diode D4, over the data pulses 13 of the pressed keys of the keyboard and diode D6 in order to generate the logic level of end pulse 15.

The means 12 for controlling the carrier wave comprise an inverter IC5E and an OR-circuit IC6C. The pulse sequence describing the message obtained from the message-generating means 11 interrupts by means of the OR-circuit IC6C, which is e.g. of the type 74HC32, the carrier wave S4 derived from the divider circuit IC 1 of the key indicating unit over the schmitt-trigger inverter IC5E, which is e.g. of the type 74HC14, and conducts it to the IR transmitter 4.

The message frame in figure 6 consists of two start pulses 12 and end pulse 15 and of an intermediate period 20, a pulse 13 (14) being sent during its specific period for each key stroke. The message pulses serve to control, in this case interrupt, the carrier wave S4, and this is further used to control the IR transmitter 4.

The IR transmitter 4 in figure 5 comprises resistors R7 and R8, the IR LEDs D7 and D8 and transistors Q1 and Q2. The control signal DS 1 of the IR transmitter derived from the carrier wave control means 12 is conducted by means of resistors R7 and R8 and transistors Q1 and Q2 to IR LEDs D7 and D8 with the IR transmitter.

The operation of the remote control of the invention will be described below. Assumedly the user presses one of the keys on the remote control, and hence the push-button switch SW1 at the same time. Key conductor K1 is thus connected as the conductive conductor of the push-button switch. As the remote control user starts pressing key 1, the key indicating unit 1 indicates a random key conductor, to which an activating signal is fed, or the key-indicating unit generates a start or end signal. Successive activation of key conductors takes place at multiple frequency of the IR transmitter carrier wave, e.g. 1 kHz, and hence the activation of a key conductor corresponding to the second key occurs very soon after the key has been pressed. Then a parallel binary number 01000 is obtained in the outputs Q6, Q7, Q8, Q9, Q10 of the divider circuit IC1 of the key-indicating unit 1, this binary number being defined as the binary address of key conductor K1. The binary address of key conductor K1 mentioned above is fed to the inputs 1a, 2a, 4a, EN; 1b, 2b, 4b, EN; 1c, 2c, 4c, EN of the decoding circuits IC2, IC3, IC4 of the binary decoder 8. As a result of this, the 0 bits are converted into 1 bits in the input of the decoding circuit IC2 EN, and this decoder carries out the interpretation of the remaining binary address code 010, i.e. bit 1 of input 2a.

As a result of this, the output a2 of decoding circuit IC2 is connected over the diode to the earthing level, whereby an activating signal A1 is generated to key conductor K1. Key 1 being still pressed, the capacitor C2 of the means 9 for forming the first time constant is discharged over diode D1, and capacitor C2 together with resistor R4 form a first time constant, which is prepared by inverters IC5A and IC5B into a logic level 1, which actuates the remote control at least during one empty message frame. While the first time constant is actuating the remote control, the divider circuit IC1 of the key-indicating unit 1 has meanwhile been reset and started the counting ascending from the beginning. In the outputs of the divider circuit IC1, a parallel binary number 00000 is then obtained, which is the binary address of the start signal. As a result of this, the output a0 of the decoding circuit IC2 is connected to the earthing level, and a start signal S1 is generated. Having awaited the start signal, the OR-gate IC6A discharges capacitor C5 over diode D2. Capacitor C5 and resistor R5 form a second time constant, which the inverters IC5C and IC5D prepare into a logic level 1, which starts the key data transmission through the OR-gate IC6B. As an activating signal A1 is being generated during a new successive reading cycle while the key 1 of key conductor K1 is being pressed, a pulse 13 indicating the stroke of key 1 is generated in resistor R6 over diode D4. Accordingly, during consecutive reading cycles, a start pulse 12 is generated in resistor R6 over diode D3 and D5 and an end pulse 15 over diode D6. These start and end pulses indicating the key stroke form a message frame, figure 6, which interrupts the carrier wave of the IR transmitter 4 obtained from the divider circuit IC1 of the key-indicating unit over the OR-circuit IC6C and generates a control signal DS1 of the IR transmitter.

It is obvious to those skilled in the art that the invention is not restricted to the disclosure above, but may vary within the scope of the following claims. Thus, for instance, the IR communication and IR transmitter can be replaced with any other wireless communication and transmitter, such as radio communication and radio transmitter, or optionally even line communication and a transmitter suitable for this.

## Claims

1. A method for controlling the operation of a remote control, the remote control comprising a feed device, such as a keyboard and/or a mouse or a similar pointer, which includes keys or push-buttons equipped with switches and disposed in related key conductors, and a transmitter for transmitting feed device data further to a computer or a similar host device, **characterised in**
- generating start signals (S1 and S2) and an end signal (S3) and intermediate successive activating signals (A1,...,A20) for the key conductor (K1,...,K20) corresponding to each key for intermittent indication of these;
- observing each key conductor (K1,...,K20) and detecting each pressed key on the basis of an activating signal (A1,...,A20); and
- generating a transmitter control signal (DS1) on the basis of the start signals (S1 and S2) and the end signal (S3) and the activating signals (A1,...,A20) of each pressed key.

2. A method as defined in claim 1, **characterised in that** the start signals and (S1 and S2) and the end signal (S3) and the intermediate successive activating signals (A1,...,A20) for the key conductor (K1,...,K20) corresponding to each key are generated by generating successive addresses corresponding to the start and end signals and the intermediate successive activating signals, and by decoding these successive addresses and changing the voltage level of the conductor corresponding to a decoded address to a level other than the release level.

3. A method as defined in claim 1 or 2, **characterised in that** a pressed key is detected when a first time constant starts during each successive reading cycle as a result of the change of voltage level caused by the activating signal (A1,...,A20) corresponding to each key stroke in each key conductor (K1,...,K20) corresponding to the pressed key.

4. A method as defined in claim 1, 2 or 3, **characterised in that** the transmitter control signal (DS1) is generated by generating a pulse corresponding to the start signal (S1 and S2) and the end signal (S3) and the activating signal (A1,...,A20) of each key stroke during its own time period (14), a prevailing second time constant activating the transmission.

5. A remote control comprising a feed device, such as a keyboard and/or a mouse or a similar pointer, which comprises keys or push-buttons equipped with switches and disposed in related key conductors, and a transmitter for transmitting feed device data further to a computer or a similar host device, **characterised in that** the remote control further comprises
- means for generating start signals (S1 and S2) and an end signal (S3) and intermediate successive activating signals (A1,...,A20) for the key conductor (K1,...,K20) corresponding to each key for intermittent successive indication of these;
- means for observing each key conductor (K1,...,K20) and means for detecting each pressed key on the basis of the activating signal (A1, ...,A20); and
- means for generating a transmitter control signal (DS1) on the basis of the start signals (S1 and S2) and the end signal (S3) and the activating signal (A1,...,A20) of each detected pressed key.

6. A remote control as defined in claim 5, **characterised in that** the means for generating start signals (S1 and S2) and the end signal (S3) and intermediate successive activating signals (A1,...,A20) for the key conductor (K1,...,K20) corresponding to each key comprise addressing means (6) for generating addresses corresponding to the start signal (S 1 and S2) and the end signal (S3) and intermediate successive activating signals (A1, ...,A20) and means (8) for decoding these successive addresses and for changing the voltage level of the conductor corresponding to a decoded address.

7. A remote control as defined in claim 5 or 6, **characterised in that** the means for detecting a pressed key comprise means (9) for forming a first time constant.

8. A remote control as defined in claim 5, 6 or 7, **characterised in that** the means for generating the transmitter control signal comprise means (10) for forming a second time constant, means (11) for generating a message and means (12) for carrier wave control.

## Patentansprüche

1. Verfahren zur Steuerung der Bedienung einer Fernbedienung, wobei die Fernbedienung eine Eingabevorrichtung, zum Beispiel eine Tastatur und/oder eine Maus oder ein ähnliches Zeigegerät, die Tasten oder Druckschalter umfasst, die mit Schaltern ausgestattet und in zugeordneten Leiterbahnen angeordnet sind, und einen Sender zur Übertragung von Daten aus der Eingabevorrichtung an einen Rechner oder eine ähnliche Hosteinrichtung, aufweist, **gekennzeichnet durch**
- das Erzeugen von Anfangssignalen (S1 und S2) und eines Endsignals (S3) und von dazwischen liegenden aufeinander folgenden Betätigungssignalen (A1, ..., A20) für die einer jeweiligen Taste zugeordnete Leiterbahn (K1, ..., K20) zur intermittierenden Angabe dieser Tasten;
- das Überwachen einer jeden Leiterbahn (K1, ..., K20) und das Erfassen einer jeden gedrückten Taste aufgrund eines Betätigungssignals (A1, ..., A20); und
- das Erzeugen eines Sender-Steuersignals (DS1) aufgrund der Anfangssignale (S1 und S2) und des Endsignals (S3) und der Betätigungssignale (A1, ..., A20) einer jeden gedrückten Taste.

2. Verfahren nach Anspruch 1, **dadurch gekennzeichnet, dass** die Anfangssignale (S1 und S2) und das Endsignal (S3) und die dazwischen liegenden aufeinander folgenden Betätigungssignale (A1, ..., A20) für die einer jeweiligen Taste zugeordnete Leiterbahn (K1, ..., K20) **dadurch** erzeugt werden, dass aufeinander folgende Adressen erzeugt werden, die den Anfangs- und Endsignalen und den dazwischen liegenden aufeinander folgenden Betätigungssignalen entsprechen, und dass diese aufeinander folgenden Adressen entschlüsselt werden und der Spannungspegel der einer entschlüsselten Adresse entsprechenden Leiterbahn auf einen Pegel gebracht wird, der von dem Freigabepegel verschieden ist.

3. Verfahren nach Anspruch 1 oder 2, **dadurch gekennzeichnet, dass** eine gedrückte Taste dann erfasst wird, wenn aufgrund der Änderung im Spannungspegel, die durch das Betätigungssignal (A1, ..., A20), das einem jeweiligen Tastenschlag in der jeweiligen der gedrückten Taste entsprechenden Leiterbahn (K1, ..., K20) entspricht, hervorgerufen wurde, eine erste Zeitkonstante während jedem nacheinander stattfindenden Lesezyklus beginnt.

4. Verfahren nach Anspruch 1, 2 oder 3, **dadurch gekennzeichnet, dass** das Steuersignal (DS1) des Senders durch Erzeugen eines Impulses erzeugt wird, welcher den Anfangssignalen (S1 und S2) und dem Endsignal (S3) und dem Betätigungssignal (A1, ..., A20) eines jeden Tastenschlags während seines eigenen Zeitintervalls (14) entspricht, wobei eine herrschende zweite Zeitkonstante die Übertragung aktiviert.

5. Fernbedienung umfassend eine Eingabevorrichtung, zum Beispiel eine Tastatur und/oder eine Maus oder ein ähnliches Zeigegerät, die Tasten oder Druckschalter umfasst, die mit Schaltern ausgestattet und in zugeordneten Leiterbahnen angeordnet sind, und einen Sender zur Übertragung von Daten aus der Eingabevorrichtung an einen Rechner oder eine ähnliche Hosteinrichtung, **dadurch gekennzeichnet, dass** die Fernbedienung ferner umfasst:
- Mittel zur Erzeugung von Anfangssignalen (S1 und S2) und eines Endsignals (S3) und von dazwischen liegenden aufeinander folgenden Betätigungssignalen (A1 ..., A20) für die einer jeweiligen Taste zugeordnete Leiterbahn (K1, ..., K20) zur intermittierenden Angabe dieser Tasten;
- Mittel zur Überwachung einer jeden Leiterbahn (K1, ..., K20) und Mittel zum Erfassen einer jeden gedrückten Taste aufgrund eines Betätigungssignals (A1, ..., A20); und
- Mittel zur Erzeugung eines Sender-Steuersignals (DS1) aufgrund der Anfangssignale (S1 und S2) und des Endsignals (S3) und der Betätigungssignale (A1, ..., A20) einer jeden gedrückten Taste.

6. Fernbedienung nach Anspruch 5, **dadurch gekennzeichnet, dass** die Mittel zur Erzeugung von Anfangssignalen (S1 und S2) und eines Endsignals (S3) und von dazwischen liegenden aufeinander folgenden Betätigungssignalen (A1, ..., A20) für die einer jeweiligen Taste entsprechende Leiterbahn (K1, ..., K20) Adressierungsmittel (6) zur Erzeugung von Adressen, die den Anfangssignalen (S1 und S2) und dem Endsignal (S3) und den dazwischen liegenden Betätigungssignalen (A1, ..., A20) entsprechen, und Mittel (8) zur Entschlüsselung dieser aufeinander folgenden Adressen und zur Änderung des Spannungspegels der einer entschlüsselten Adresse entsprechenden Leiterbahn aufweisen.

7. Fernbedienung nach Anspruch 5 oder 6, **dadurch gekennzeichnet, dass** die Mittel zum Erfassen einer gedrückten Taste Mittel (9) zur Bildung einer ersten Zeitkonstante aufweisen.

8. Fernbedienung nach Anspruch 5, 6 oder 7, **dadurch gekennzeichnet, dass** die Mittel zur Erzeugung des Sender-Steuersignals des Senders Mittel (10) zur Bildung einer zweiten Zeitkonstante, Mittel (11) zur Erzeugung einer Nachricht und Mittel (12) zur Steuerung der Trägerwelle aufweisen.

## Revendications

1. Procédé pour commander le fonctionnement d'une commande à distance, la commande à distance comprenant un dispositif de saisie, tel qu'un clavier et/ou une souris ou un pointeur similaire, qui comprend des touches ou des boutons-poussoirs équipés d'interrupteurs et disposés dans des conducteurs de touche connexes, et un émetteur pour transmettre des données de dispositif de saisie à un ordinateur ou un dispositif hôte similaire, **caractérisé par** :
- la génération des signaux de début (S1 et S2) et un signal de fin (S3) et des signaux d'activation successifs intermédiaires (A1, ..., A20) pour le conducteur de touche (K1, ..., K20) correspondant à chaque touche pour une indication intermittente de ceux-ci ;
- l'observation de chaque conducteur de touche (K1, ..., K20) et la détection de chaque touche actionnée sur la base d'un signal d'activation (A1, ... , A20) ; et
- la génération d'un signal de commande d'émetteur (DS1) sur la base des signaux de début (S1 et S2) et du signal de fin (S3) et des signaux d'activation (A1, ..., A20) de chaque touche actionnée.

2. Procédé selon la revendication 1, **caractérisé en ce que** les signaux de début (S1 et S2) et le signal de fin (S3) et les signaux d'activation successifs intermédiaires (A1, ..., A20) pour le conducteur de touche (K1, ..., K20) correspondant à chaque touche actionnée sont générés en générant des adresses successives correspondant aux signaux de début et de fin et aux signaux d'activation successifs intermédiaires et en décodant ces adresses successives et en changeant le niveau de tension du conducteur correspondant à une adresse décodée à un niveau autre que le niveau de relâchement.

3. Procédé selon la revendication 1 ou 2, **caractérisé en ce qu'**une touche actionnée est détectée quand une première constante de temps commence durant chaque cycle de lecture successif en conséquence du changement de niveau de tension provoqué par le signal d'activation (A1, ..., A20) correspondant à chaque actionnement de touche dans chaque conducteur de touche (K1, ..., K20) correspondant à la touche actionnée.

4. Procédé selon la revendication 1, 2 ou 3, **caractérisé en ce que** le signal de commande d'émetteur (DS1) est généré en générant une impulsion correspondant au signal de début (S1 et S2) et au signal de fin (S3) et au signal d'activation (A1, ..., A20) de chaque actionnement de touche durant sa propre période de temps (14), une deuxième période de temps dominante activant la transmission.

5. Commande à distance comprenant un dispositif de saisie, tel qu'un clavier et/ou une souris ou un pointeur similaire, qui comprend des touches ou des boutons-poussoirs équipés d'interrupteurs et disposés dans des conducteurs de touche connexes, et un émetteur pour transmettre des données de dispositif de saisie à un ordinateur ou un dispositif hôte similaire, **caractérisé en ce que** la commande à distance comprend en outre :
- des moyens pour générer des signaux de début (S1 et S2) et un signal de fin (S3) et des signaux d'activation successifs intermédiaires (A1, ..., A20) pour le conducteur de touche (K1, ..., K20) correspondant à chaque touche pour une indication intermittente successive de ceux-ci ;
- des moyens pour observer chaque conducteur de touche (K1, ..., K20) et des moyens pour détecter chaque touche actionnée sur la base d'un signal d'activation (A1, ... , A20) ; et
- des moyens pour générer un signal de commande d'émetteur (DS1) sur la base des signaux de début (S1 et S2) et du signal de fin (S3) et du signal d'activation (A1, ..., A20) de chaque touche actionnée détectée.

6. Commande à distance selon la revendication 5, **caractérisée en ce que** les moyens pour générer des signaux de début (S1 et S2) et le signal de fin (S3) et des signaux d'activation successifs intermédiaires (A1, ..., A20) pour le conducteur de touche (K1, ..., K20) correspondant à chaque touche comprend des moyens d'adressage (6) pour générer des adresses correspondant au signal de début (S1 et S2) et au signal de fin (S3) et aux signaux d'activation successifs intermédiaires (A1, ..., A20) et des moyens (8) pour décoder ces adresses successives et pour changer le niveau de tension du conducteur correspondant à une adresse décodée.

7. Commande à distance selon la revendication 5 ou 6, **caractérisée en ce que** les moyens pour détecter une touche actionnée comprennent des moyens (9) pour former une première constante de temps.

8. Commande à distance selon la revendication 5, 6 ou 7, **caractérisée en ce que** les moyens pour générer le signal de commande d'émetteur comprennent des moyens (10) pour former une deuxième constante de temps, des moyens (11) pour générer un message et des moyens (12) pour la commande d'onde porteuse.
